# EUROPEAN PATENT APPLICATION

(11) **EP 1 460 697 A2**
(43) Date of publication of application: **22.09.2004**
(21) Application number: 04251435.6
(22) Date of filing: 12.03.2004
(51) Int. Cl.: H01L 51/20

(54) **Organic electroluminescene display panel and fabrication method thereof**

(30) Priority: 17.03.2003 JP 2003071423
(71) Applicant: Pioneer Corporation, Meguro-ku, Tokyo (JP)
(72) Inventor: Kubota, Hirofumi, Tsurugashima-shi Saitama 350-2288 (JP)
(74) Representative: Maury, Richard Philip

(57) **Abstract**

An organic electroluminescence display panel has an enhanced shielding capability whereby degradation of light emission characteristics does not readily occur. This display panel includes one or more organic electroluminescence elements (28), and each organic electroluminescence element includes first (13) and second display electrodes (15) and one or more organic functional layers (14). The organic functional layer(s) (14) is interposed between the first (13) and second display electrodes (15). The organic functional layer includes an organic compound. The display panel also includes a substrate (10) for supporting the organic electroluminescence element(s). The display panel further includes a high molecular compound film consisting of polyurea or polyimide (16P) that covers the organic electroluminescence element and the peripheral substrate surface. The display panel also includes an inorganic barrier film (16S) that covers the high molecular compound film (16P), the edge face thereof (E), and the peripheral substrate surface (R2).

## Description

### BACKGROUND OF THE INVENTION

### 1. Field of the Invention

The present invention relates to an organic electroluminescence element (hereinafter referred to as an 'organic EL element') that includes one or more thin films each having a light emission layer (hereinafter referred to as 'organic functional layers'). The light emission layer is made from an organic compound material that exhibits electroluminescence in which light emission takes place due to application (injection) of a current.

The present invention also relates to an organic electroluminescence display panel (hereinafter referred to as an 'organic EL display panel' ) having a substrate and one or more Organic EL elements formed on the substrate.

### 2. Description of the Related Art

In general, an organic EL element is formed such that an organic functional layer is interposed between an anode and a cathode. Excitons are formed when electrons and positive holes that are implanted from the electrodes (i.e., the cathode and anode) are recombined. The organic EL element generates light when the excitons return to a base state from an excited state. For example, an organic EL element is formed by sequentially laminating a transparent electrode constituting an anode, an organic functional layer, and a metal electrode constituting a cathode, on a transparent substrate, and light emission is obtained from the transparent substrate side. In general, the organic functional layer is a single-layer light emission layer or is a laminate body with a three-layer structure consisting of an organic positive hole carrier layer, a light emission layer and an organic electron carrier layer, or a two-layer structure consisting of an organic positive hole carrier layer and light emission layer. An electron or positive-hole injection layer and/or a carrier block layer is sometimes inserted between suitable layers of the aforementioned layers.

Known examples of organic EL display panels include the matrix display type and those having a predetermined light emission pattern.

When exposed to the atmosphere, these organic EL elements degrade readily under the effects of moisture, gases such as oxygen, and other molecules of a certain type in a given environment. Characteristic degradation is particularly prominent at the interfaces between the electrodes of the organic EL element and the organic functional layer. The characteristic degradation often causes a drop in light emission characteristics such as luminance, color, and so forth. In order to prevent the characteristic degradation of the organic EL display panel, the organic EL element is sealed by means of an inorganic single-layer protective film of silicon oxide or the like. However, such a protective film does not possess adequate barrier properties. This is because the generation of pinholes in the inorganic barrier film (protective film) is unavoidable. When pinholes exist in the protective film, moisture, oxygen, and so forth penetrate into the organic EL element via the pinholes, resulting in expansion of so-called dark spots in the organic EL element. No light emission occurs in the dark spots.

### SUMMARY OF THE INVENTION

One object of the present invention is to provide an organic EL element in which an organic functional layer and electrodes are afforded the property of high insulation with respect to oxygen and moisture and so forth, so that the degradation of light emission characteristics does not readily occur.

Another object of the present invention is to provide an organic EL display panel that can prevent penetration of oxygen, moisture and the like.

According to one aspect of the present invention, there is provided a novel organic EL display panel having a plurality of organic EL elements. Each organic EL element of the display panel includes first and second display electrodes and one or more organic functional layers. The organic functional layer includes an organic compound and is laminated between the first and second display electrodes. The display panel also includes a substrate for supporting the organic EL elements. A high molecular compound film, made of polyurea or polyimide, for example, is provided over the organic EL elements on the substrate to cover the organic EL elements and their peripheral areas on the substrate surface. An inorganic barrier film is also provided to cover the high molecular compound film, its edge face, and its peripheral substrate surface. It should be noted that the inorganic barrier film may be formed over the organic EL element, and then the high molecular compound film may be formed on the inorganic barrier film.

According to another aspect of the present invention, there is provided a method of fabricating an organic EL display panel. First, a substrate is prepared. Then, at least one organic EL element is formed on the substrate. Each organic EL element has first and second display electrodes and at least one organic functional layer made from an organic compound. The organic functional layer is laminated between the first and second display electrodes. A first sealing film is deposited over the organic EL element. The first sealing film has a larger area than the organic EL element so as to cover the organic EL element and a peripheral area of the organic EL element on the substrate. A second sealing film is deposited over the first sealing film. The second sealing film has a larger area than the first sealing film so as to cover the first sealing film, an edge portion of the first sealing film, and a peripheral area of the first sealing film on the substrate. The first sealing film may be a high molecular compound film, made from polyurea or polyimide, and the second sealing film may be an inorganic barrier film. Alternatively, the first sealing film may be an inorganic barrier film, and the second sealing film may be a high molecular compound film, made from polyurea or polyimide.

Other objects, aspects and advantages of the present invention will become apparent to those skilled in the art to which the present invention pertains from the following detailed description and the appended claims when taken in conjunction with the accompanying drawings.

### BRIEF DESCRIPTION OF THE DRAWINGS

Figure 1 is a perspective view of an organic EL device according to an embodiment of the present invention;
Figure 2 is a perspective view of a substrate and an organic EL element at a certain step in the organic EL display panel fabrication method according to one embodiment of the present invention;
Figure 3 is a perspective view of the substrate, organic EL element and a first sealing film at a next step in the organic EL display panel fabrication method;
Figure 4 is a perspective view of the substrate, organic EL element, first sealing film and a second sealing film at a next step in the organic EL display panel fabrication method;
Figure 5 is a partially enlarged rear view of an organic EL display panel that includes a plurality of organic EL elements, according to another embodiment of the present invention;
Figure 6 is a perspective view of an organic EL device according to still another embodiment of the present invention;
Figure 7 is a perspective view of an organic EL device of another embodiment according to the present invention; and
Figure 8 is a perspective view of an organic EL device of another embodiment according to the present invention.

### DETAILED DESCRIPTION OF THE INVENTION

Embodiments according to the present invention will be described hereinbelow with reference to the drawings.

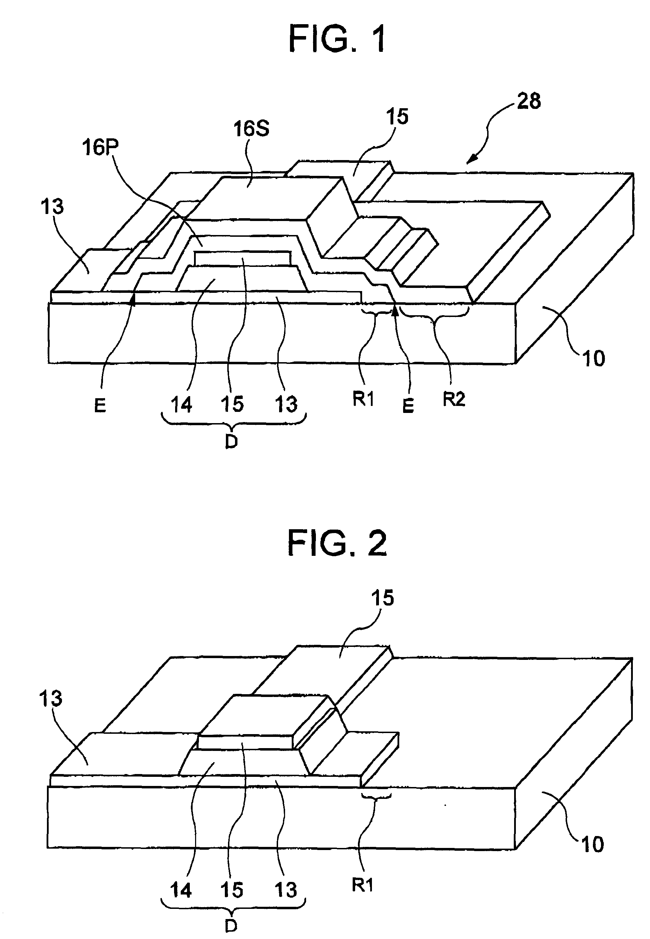

Referring to Figure 1, an organic EL device 28 of this embodiment includes a substrate 10, a first display electrode 13 (transparent electrode anode), one or more organic functional layers 14 each having a light emission layer made of an organic compound, and a second display electrode 15 (metal electrode cathode), which are sequentially deposited on the substrate 10. The combination of the first display electrode 13, organic functional layer(s) 14 and second display electrode 15 is referred to as an organic EL element D in this specification. The substrate 10 is made of glass or the like. The organic EL device 28 also includes a multi-layer sealing part made from two films, i.e., a high molecular compound film 16P and an inorganic barrier film 16S which are laminated in this order, to cover the top surface of the second display electrode 15. The high molecular compound film 16P is a polyurea or polyimide film formed by vapor deposition polymerization. The high molecular compound film 16P covers the organic EL element D and its peripheral area (surface) R1 on the substrate 10. The inorganic barrier film 16S covers the high molecular compound film 16P, its edge portion E, and its peripheral area (surface) R2 on the substrate 10. The edge face E of the high molecular compound film 16P is formed having a film thickness that gradually decreases (or a tapered shape) in order to secure smooth or easy deposition of the inorganic barrier film 16S. There are no limitations on the material of the substrate 10 so that an organic material such as a high molecular compound may be used for the substrate 10, or an inorganic material such as glass may be used for the substrate 10.

As described above, the organic EL element D has, over itself, a multi-layered deposition structure consisting of the inorganic barrier film 16S and the high molecular compound film 16P. It should be noted that the reversed deposition order is acceptable for the inorganic barrier film 16S and the high molecular compound film 16P, i.e., the barrier film 16S may be formed on the organic EL element D, and the high molecular compound film 16P may be formed over the barrier film 16S.

The organic EL device 28 is fabricated by means of the following procedure.

First, the main body of the organic EL device 28 is fabricated as shown in Figure 2. The first display electrode 13, which is made of indium tin oxide (ITO), is deposited on the substrate 10 by means of vapor deposition or sputtering. Subsequently, a predetermined pattern is formed by means of a photolithographic process. Next, the organic functional layer 14 is formed by using vapor deposition to sequentially deposit, on top of this predetermined pattern, a positive hole injection layer made of copper phthalocyanine, a positive hole carrier layer made of TPD (triphenylamine derivative), a light emission layer made of an Alq3 (aluminum chelate complex), and an electron injection layer made of Li₂O (lithium oxide). Then, the second display electrode 15 made of Al is deposited, by means of vapor deposition, on top of the organic functional layer 14 to face the electrode pattern of the transparent electrode 13 via the organic functional layer 14.

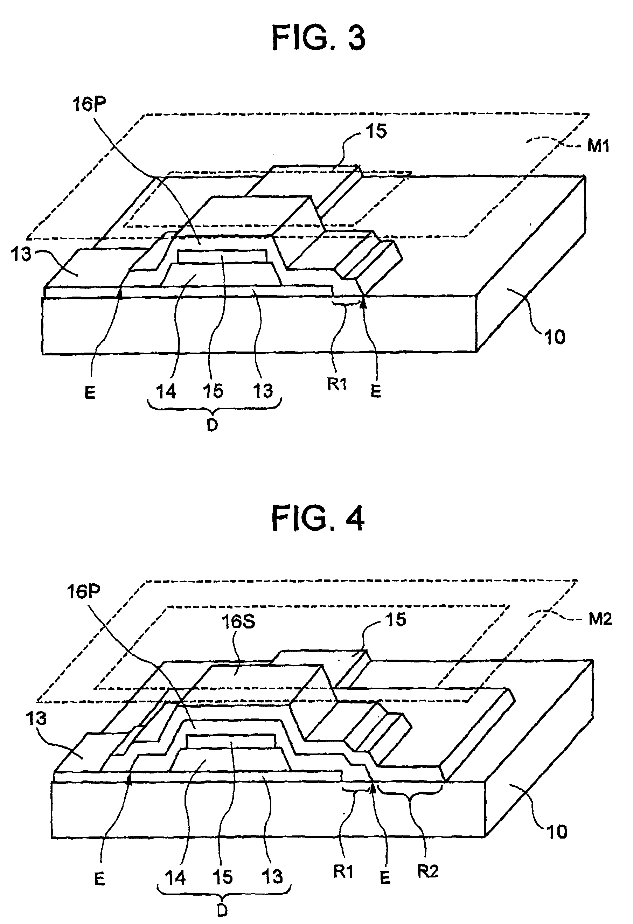

Next, as shown in Figure 3, a polyurea or polyimide film is deposited by means of vapor deposition polymerization as the high molecular compound film 16P atop the organic EL element D. The vapor deposition polymerization is carried out within a vacuum chamber of a vapor deposition polymerization device (not shown). In the vacuum chamber of the device, the high molecular compound film 16P is deposited over a larger area than a display region containing a pixel or organic EL element D by using a first mask M1. The first mask M1 has an opening of predetermined shape for passage of a aterial of the high molecular compound film 16P.

Gas within the high molecular compound film 16P is removed by annealing the polyurea or polyimide film 16P deposited on the organic EL element D at or below a temperature (about 100°C) of a magnitude so as not to damage the organic functional layer 14 in a vacuum or an inert gas such as N₂. Then, the inorganic film 16S is deposited as described below (Figure 4).

The substrate 10 of Figure 3 is removed from the vapor deposition polymerization device and then loaded into a chamber of a plasma chemical vapor deposition device (not shown). As shown in Figure 4, a silicon nitride film (i.e., inorganic barrier film 16S) is deposited atop the high molecular compound film 16P by means of plasma chemical vapor deposition. The inorganic barrier film 16S is deposited over a larger area than the high molecular compound film 16P by using a second mask M2, whereby the organic EL device 28 shown in Figure 1 is created. The second mask M2 has an opening for passage of the inorganic material. The opening of the second mask M2 is larger than the first opening mask M1. Hence, the inorganic barrier film 16S is deposited so as to cover the edge face of the high molecular compound film 16P and the peripheral area on the substrate 10. In Figure 4, one pair of high molecular compound film 16P and inorganic barrier film 16S is provided over the organic EL element D. If a plurality of pairs of high molecular compound film 16P and inorganic barrier film 16S should be provided over the organic EL element D, the above described deposition processes may be repeated so that the films 16P and 16S are alternately laminated.

In the vapor deposition polymerization process to prepare the high molecular compound film 16P, two or more types of organic molecule are vaporized and gasified within the vacuum chamber, and the gas thus generated comes into contact with a predetermined coated surface, reacts therewith, and is deposited thereon, whereby organic molecules are polymerized. In other words, this is a film deposition method in which a polymer thin film is fabricated by causing a monomer to undergo a polymerization reaction in a vacuum. With vapor deposition polymerization, a high molecular compound film can be obtained as long as the monomer or oligomer possesses the vapor pressure. Polyimide is a polymer having a molecular structure of, for example, imide ring (heterocyclic ring), aromatic ring, or the like, that is thermochemically stable in the principal chain, and is highly superior in terms of its heat resistance, mechanical strength, electrical insulation properties, and chemical resistance. Polyurea or polyimide is preferably used as the high molecular compound film. The polyimide film is deposited by performing condensation polymerization of pyromellitic dianhydride and a diamine monomer. Raw materials for the polyurea film include MDI (4, 4' diphenylmethane diisocyanate), ODA (4, 4' diamine phenylethyl), or the like, for example. When dry process vapor deposition polymerization is employed such that a thin film of polyimide or polyurea or the like is polymerized at the substrate surface by means of the codeposition of a bifunctional monomer, or the like, a high purity polymer thin film is obtained because no solvent is employed. The dry process vapor deposition polymerization can also control the film thickness of the polymer thin film. Further, straightforward formation of the film pattern is possible because mask vapor deposition is permitted in the dry process vapor deposition polymerization.

Catalytic chemical vapor deposition used to deposit the inorganic barrier film 16S differs from plasma chemical vapor deposition. In the catalytic chemical vapor deposition, thin film molecules are generated from raw materials by using high temperature catalysis and then deposited on the substrate. The thin film is not damaged, and characteristics of the thin film are not degraded. The plasma chemical vapor deposition, on the other hand, would damage and degrade the thin film. Although the catalyst itself is about 1000°C or more in the catalytic chemical vapor deposition, the thin film, which is supported by a cooling holder, is kept at or below about 100° C, and hence the organic EL element is not damaged. The catalytic chemical vapor deposition is chemical vapor deposition employing thermal catalysis that uses a material gas decomposition reaction at the surface of a catalyst wire consisting of a high temperature metal or metal compound. The metal or metal compound of the catalyst wire may be selected from tungsten, tantalum, molybdenum, titanium, or vanadium, or an alloy of two or more of these elements, for example. When a silicon nitride film is deposited, film deposition is carried out by using silane gas (SiH₄) and ammonia gas (NH₃), for example. The catalytic chemical vapor deposition device includes a vacuum chamber inside which the substrate undergoes a predetermined treatment. A gas supply system, which supplies a predetermined material gas for the inorganic barrier film, and an exhaust system such as a vacuum pump, are connected to the vacuum chamber. A tungsten or other catalyst wire, and a cooling holder for holding the substrate on which an inorganic barrier film is created as a result of a reaction involving the catalyst wire, are provided within the vacuum chamber such that material gas passes close to the surface of the catalyst wire.

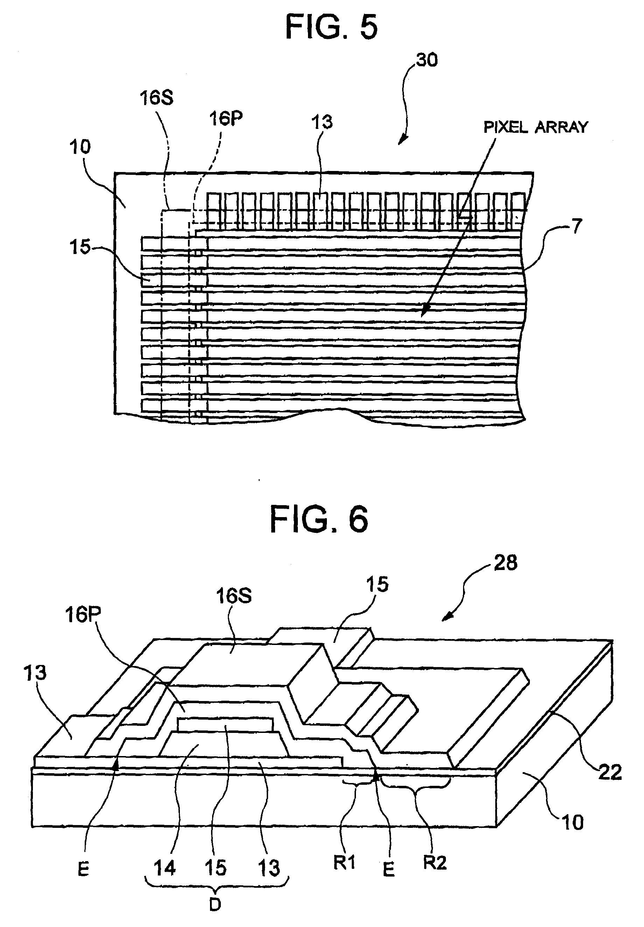

Figure 5 is a partially enlarged rear view of an organic EL display panel 30. This organic EL display panel 30 includes a plurality of organic EL elements D arranged in the form of a matrix on the substrate 10. The organic EL display panel 30 is constituted by sequentially laminating, on the substrate 10, row electrodes 13 having a transparent electrode layer (first display electrodes of the anode), an organic functional layer, and column electrodes 15 having a metal electrode layer (second display electrodes). The column electrodes 15 cross the row electrodes 13 at right angles. The row electrodes 13 are each formed having a belt (or band) shape and arranged in parallel at predetermined intervals from each other. Similarly, the column electrodes 15 are each formed having a belt shape and arranged in parallel at predetermined intervals from each other. The matrix-display-type display panel 30 has an array of pixels. Specifically, a plurality of light emitting pixels (i.e., a plurality of organic EL elements) is formed at intersections of the row electrodes 13 and column electrodes 15 in the display panel 30. The organic EL display panel 30 may also include a plurality of partition walls 7 provided in parallel between the organic EL elements on the substrate 10. The high molecular compound film 16P is formed over the second display electrodes 15, the partition walls 7 and the peripheral area, so as to cover the organic EL elements completely. Once this high molecular compound film 16P has been made smooth, the inorganic barrier film 16S is formed thereon. The materials for the organic functional layer(s) may be selected and laminated to form red R, green G or blue B light emission portions.

Figure 6 shows an organic EL device 28 according to another embodiment of the present invention. Similar reference numerals and symbols are used to designate similar parts in Figures 1 and 6. This organic EL device 28 is the same as that of the embodiment shown in Figure 1 except for the fact that the substrate 10 is a plastic substrate consisting of a synthetic resin and the surface of the substrate 10 is covered with a barrier film 22 consisting of an inorganic material such as silicon nitride or silicon oxynitride (SiON). The first and second electrodes 13 and 15 of the organic EL element are formed on the inorganic barrier film 22. A film of polyethylene terephthalate, polyethylene-2,6-naphthalate, polycarbonate, polysulphone, polyethylsulphone, polyethylethylketone, polyphenoxyethyl, polyarylate, fluorine resin, polypropylene, or the like, can be used as the synthetic resin substrate 10.

The surface of the plastic substrate 10 covered with the inorganic barrier film 22 preferably includes at least a surface that makes contact with the organic EL element D, a surface surrounding the organic EL element D, and a surface between the organic EL element D and an adjacent organic EL element (not shown). A surface on the rear side of the substrate 10 opposite the organic EL element D may also be covered with another barrier film (not shown). The barrier film(s) 22 prevent (s) penetration of outgas from the plastic substrate 10 to the organic functional layer 14. Further, warping of the plastic substrate 10 can be prevented by covering (sandwiching) both sides of the plastic substrate 10 with the inorganic barrier films 22.

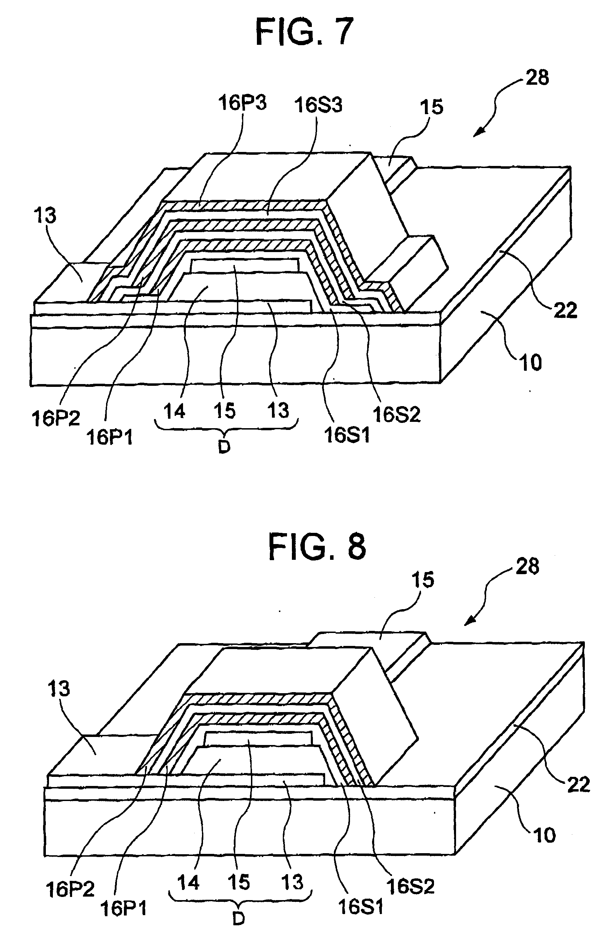

Figure 7 shows an organic EL device 28 of another embodiment of the present invention. Similar reference numerals and symbols are used to designate similar parts in Figures 6 and 7. In this embodiment, the organic EL element D is formed on the inorganic barrier film 22 of the substrate 10, and is protected by multiple-layer sealing part including the films 16S1, 16P1, 16S2, 16P2, 16S3 and 16P3. Specifically, on the organic EL element D, there are provided a first inorganic barrier film 1651, a first high molecular compound film 16P1, a second inorganic barrier film 16S2, a second high molecular compound film 16P2, a third inorganic barrier film 16S3, and a third high molecular compound film 16P3 in that order. The top surface of the second display electrode 15 is in contact with the first inorganic barrier film 16S1. In order to laminate these inorganic barrier films 16S1 to 16S3 and high molecular compound films 16P1 to 16P3 alternately, the film deposition steps for the inorganic barrier film and high molecular compound film are alternately repeated. It should be noted that the lamination order of the inorganic barrier films 16S1 to 16S3 and high molecular compound films 16P1 to 16P3 may be reversed. Specifically, the first high molecular compound film 16P1 may be formed on the top surface of the second display electrode 15, the first inorganic barrier film 16S1 may be formed on the first high molecular compound film 16P1, the second high molecular compound film 16P2 may be then formed on the first inorganic barrier film 16S1, and so on.

In an experimental example, a plastic substrate (10) having an inorganic barrier film (22) was prepared, and an organic functional layer (14) was formed on an anode (13) of the plastic substrate (10). Then, an Al cathode (15) was deposited on the organic functional layer (14) to create an organic EL element (D) on the substrate (10) . After that, a polyurea high molecular compound film (16P1) was deposited by means of vapor deposition polymerization so as to cover the organic EL element (D), and a silicon nitride inorganic barrier film (16S1) was formed over the whole surface of the polyurea high molecular compound film (16P1) by means of plasma CVD. The edge (face) (E) of the high molecular compound film (16P1) and the peripheral substrate surface (R2) were also covered by the silicon nitride inorganic barrier film (16S1). The deposition processes for the polyurea high molecular compound film and silicon nitride inorganic barrier film were repeated to form a multilayered sealing (16P1, 16S1, 16P2, 16S2, 16P3 and 16S3) over the organic EL element (D). As a result, a multi-layer sealing part, which is similar to Figure 7, was made over the organic EL element (D). Further, as a comparative example, an organic EL element sealed simply by a single-layer inorganic barrier film (22) was fabricated. As for the conditions for the plasma CVD of the silicon nitride film, 10 SCCM silane (SiH₄) and 200 SCCM nitrogen gas were used, the pressure was 0.9 Torr, the RF power was 50 mW/cm², the frequency was 13.56 MHz, the substrate temperature was 100°C, and the deposited film thickness was 1.0 *µ*m. A test of the durability was conducted. In the atmosphere under the conditions of 60° C and 95% RH, the expansion of dark spots in these organic EL devices was measured. The test result revealed that there was no dark spot expansion in the organic EL device of this embodiment, but dark spot expansion occurred in the organic EL device of the comparative example.

Figure 8 illustrates another embodiment of the present invention. Similar reference numerals and symbols are used to designate similar parts in Figures 7 and 8. In this embodiment, the first inorganic barrier film 16S1 covers the organic EL element D and the peripheral substrate surface 10 (more specifically, the inorganic barrier film 22 formed on the substrate 10). The first high molecular compound film 16P1 covers the first inorganic barrier film 16S1 and the peripheral substrate surface 10. The second inorganic barrier film 16S2 covers the first high molecular compound film 16P1, the edge face (lateral face) thereof, and the peripheral substrate surface. The second high molecular compound film 16P2 covers the second inorganic barrier film 16S2, the edge face thereof, and the peripheral substrate surface. Masks having different sizes of opening are used to deposit the films 16S1, 16P1, 16S2 and 16P2 such that the respective openings of the masks allow the passage of respective deposition materials. In general, the opening of one mask has a larger size than the opening of another mask used in the preceding step. Thus, the multi-layer protective part, including the films 16S1, 16P1, 16S2 and 16P2, can be deposited in a desired manner. One film covers the edge face of the preceding film in the multi-layer part.

In the embodiments shown in Figures 7 and 8, the inside high molecular compound film (16P1; 16P2) is sandwiched and embedded between a pair of inorganic barrier films (16S1 and 16S2; 16S2 and 16S3).

In the embodiments shown in Figures 7 and 8, the inorganic barrier films 22 and 16S1 are always in contact with the organic EL element D. It can be said that the inorganic barrier film 16S1 is always in contact with the organic EL element D.

In the embodiments shown in Figures 1 to 8, a multilayered sealing part, in which at least one inorganic barrier film and at least one high molecular compound film are laminated, is provided over the organic EL element D. Therefore, pinholes that may be present in the inorganic barrier film are embedded in and rendered smooth by the high molecular compound film. Thus, the multilayered sealing part does not include defects. Further, the second (and third) inorganic barrier film is laminated over the high molecular compound film(s) in the embodiments of Figures 7 and 8. Thus, the sealing effect of the multilayered sealing part is further enhanced in these embodiments.

Although vapor deposition polymerization is employed in the above embodiments as the method for fabricating a high molecular compound film of polyureas or the like, the present invention is not restricted to this method. Chemical vapor deposition, vacuum spraying, and so-called sputtering can also be applied.

Vacuum spraying involves the deposition of a film by spraying a polymer solution via a nozzle in a vacuum or inert gas. When spraying the polymer solution in a vacuum, the solvent becomes volatile immediately and disappears before reaching the substrate. If the substrate is heated to a temperature (about 100° C) of a magnitude so as not to damage the organic functional layer of the organic EL element, the solvent becomes volatile even if the solvent remains in the film. When an inert gas is the atmosphere (i.e., when the polymer solution is sprayed in the inert gas), a solvent is preferably selected to have a volatility temperature lower than the temperature of the substrate heated, so that the solvent becomes volatile at the same time as the solution adheres to the substrate, and hence solvent that would otherwise damage the organic EL element no longer remains. In the vacuum spraying process, a fine spray is directly generated from a solution in which predetermined organic molecules and parent polymers have been dissolved, and this fine spray is rapidly solidified in a vacuum or inert gas and then deposited on the substrate. A vacuum spraying device includes a vacuum chamber, a fluid spraying device connected to the vacuum chamber, an exhaust system connected to the vacuum chamber, and a substrate heating holder located in the vacuum chamber.

Although a simplex matrix display type organic EL display panel is described in the above embodiment, the present invention can also be applied to the substrate of an active matrix display type panel using a TFT and so forth.

## Claims

1. An organic electroluminescence display panel comprising:
at least one organic electroluminescence element, each having first and second display electrodes and at least one organic functional layer consisting of an organic compound, the at least one organic functional layer being laminated between the first and second display electrodes;
a substrate for supporting the at least one organic electroluminescence element;
a high molecular compound film for covering the respective organic electroluminescence elements and a peripheral area of each said organic electroluminescence element on the substrate; and
an inorganic barrier film for covering the high molecular compound film, an edge of the high molecular compound film, and a peripheral area of the high molecular compound film on the substrate.

2. The organic electroluminescence display panel according to claim 1, wherein the high molecular compound film is made from polyurea or polyimide.

3. The organic electroluminescence display panel according to claim 1 or 2, wherein the inorganic barrier film is made from silicon nitride or silicon oxynitride.

4. The organic electroluminescence display panel according to claim 1, 2 or 3, wherein the inorganic barrier film is deposited by means of plasma chemical vapor deposition, sputtering, or catalytic chemical vapor deposition.

5. The organic electroluminescence display panel according to any one of claims 1 to 4, wherein the high molecular compound film is deposited by means of vapor deposition polymerization.

6. The organic electroluminescence display panel according to claim 5, wherein the vapor deposition polymerization includes annealing a film of polyurea or polyimide at a predetermined temperature in a vacuum or inert gas.

7. The organic electroluminescence display panel according to any one of claims 1 to 4, wherein the high molecular compound film is deposited by means of spraying a high molecular solution in a vacuum.

8. The organic electroluminescence display panel according to any one of claims 1 to 7, wherein the organic electroluminescence display panel further comprises at least one additional high molecular compound film and at least one additional inorganic barrier film, and the high molecular compound films and the inorganic barrier films are deposited in a plurality of alternately laminated layers.

9. An organic electroluminescence display panel comprising:
at least one organic electroluminescence element, each having first and second display electrodes and at least one organic functional layer consisting of an organic compound, the at least one organic functional layer being laminated between the first and second display electrodes;
a substrate for supporting the at least one organic electroluminescence element;
an inorganic barrier film for covering the respective organic electroluminescence elements and a peripheral area of each said organic electroluminescence element on the substrate; and
a high molecular compound film for covering the inorganic barrier film, an edge of the inorganic barrier film and a peripheral area of the inorganic barrier film on the substrate.

10. The organic electroluminescence display panel according to claim 9, wherein the high molecular compound film is made from polyurea or polyimide.

11. The organic electroluminescence display panel according to claim 9 or 10, wherein the inorganic barrier film is made from silicon nitride or silicon oxynitride.

12. The organic electroluminescence display panel according to claim 9, 10 or 11, wherein the inorganic barrier film is deposited by means of plasma chemical vapor deposition, sputtering, or catalytic chemical vapor deposition.

13. The organic electroluminescence display panel according to any one of claims 9 to 12, wherein the high molecular compound film is deposited by means of vapor deposition polymerization.

14. The organic electroluminescence display panel according to claim 13, wherein the vapor deposition polymerization includes annealing a film of polyurea or polyimide at a predetermined temperature in a vacuum or inert gas.

15. The organic electroluminescence display panel according to any one of claims 9 to 12, wherein the high molecular compound film is deposited by means of spraying a high molecular solution in a vacuum.

16. The organic electroluminescence display panel according to any one of claims 9 to 15, wherein the organic electroluminescence display panel further comprises at least one additional inorganic barrier film and at least one additional high molecular compound film, and the inorganic barrier films and the high molecular compound films are deposited in a plurality of alternately laminated layers.

17. A method of fabricating an organic electroluminescence display panel, the method comprising the steps of:
providing a substrate;
forming at least one organic electroluminescence element on the substrate, each said organic electroluminescence element having first and second display electrodes and at least one organic functional layer consisting of an organic compound, the at least one organic functional layer being laminated between the first and second display electrodes;
depositing a first sealing film over a larger area than each said organic electroluminescence element so as to cover each said organic electroluminescence element and a peripheral area of each said organic electroluminescence element on the substrate; and
depositing a second sealing film over a larger area than the first sealing film so as to cover the first sealing film, an edge portion of the first sealing film, and a peripheral area of the first sealing film on the substrate.

18. The fabrication method according to claim 17, wherein the first sealing film is a high molecular compound film and the second sealing film is an inorganic barrier film.

19. The fabrication method according to claim 17, wherein the first sealing film is an inorganic barrier film and the second sealing film is a high molecular compound film.

20. The fabrication method according to claim 18 or 19, wherein the high molecular compound film is made from polyurea or polyimide.

21. The fabrication method according to any one of claims 17 to 20, wherein the edge portion of the first sealing film has a tapered shape such that a film thickness of the edge portion of the first sealing film gradually decreases.

22. The fabrication method according to any one of claims 18 to 21, wherein the inorganic barrier film is made from silicon nitride or silicon oxynitride.

23. The fabrication method according to any one of claims 18 to 22, wherein the inorganic barrier film is deposited by means of plasma chemical vapor deposition, sputtering, or catalytic chemical vapor deposition.

24. The fabrication method according to any one of claims 18 to 23, wherein the high molecular compound film is deposited by means of vapor deposition polymerization or vacuum spraying.

25. The fabrication method according to claim 24, wherein the vapor deposition polymerization includes a step of annealing a polyurea or polyimide film at a predetermined temperature in a vacuum or inert gas.

26. An organic electroluminescence device comprising:
an organic electroluminescence element having first and second display electrodes and at least one organic functional layer consisting of an organic compound, the at least one organic functional layer being laminated between the first and second display electrodes;
a substrate for supporting the organic electroluminescence element;
a first sealing film for covering the organic electroluminescence element and a peripheral area of the organic electroluminescence element on the substrate; and
a second film for covering the first sealing film and a peripheral area of the first sealing film on the substrate.

27. The organic electroluminescence device according to claim 26, wherein the first sealing film is a high molecular compound film and the second sealing film is an inorganic barrier film.

28. The organic electroluminescence device according to claim 27, wherein the first sealing film is an inorganic barrier film and the second sealing film is a high molecular compound film.
